# EUROPEAN PATENT APPLICATION

(11) **EP 1 311 072 A1**
(43) Date of publication of application: **14.05.2003**
(21) Application number: 00953467.8
(22) Date of filing: 17.08.2000
(51) Int. Cl.: H04B 1/38, H01L 23/31, H01L 25/00, H05K 3/28

(54) **TRANSMITTER AND RECEIVER MODULE**

(71) Applicant: Hitachi, Ltd., Chiyoda-ku, Tokyo 101-8010 (JP)
(72) Inventor: NAKAZAWA, Terumi, c/o Hitachi, Ltd., Hitachinaka-shi, Ibaraki312-0062 (JP); TABUCHI, Kenji, c/o Hitachi, Ltd., Hitachinaka-shi, Ibaraki 312-0062 (JP); EGUCHI, Shuji, Hitachi, Ltd., Hitachinaka-shi, Ibaraki 312-0062 (JP); FUJITA, Tsuyoshi, c/o Hitachi, Ltd., Hitachinaka-shi, Ibaraki312-0062 (JP); SHIGI, Hidetaka, c/o Hitachi, Ltd., Hitachinaka-shi, Ibaraki 312-0062 (JP)
(74) Representative: Beetz & Partner Patentanwälte
(86) International application number: JP0005509
(87) International publication number: WO02015423

(57) **Abstract**

The transmitter-receiver module has partial packages in which only some of the IC dies and other electronic components constituting the transmitter-receiver circuits for use on millimeter wave or semi-millimeter wave bands are to be sealed, and a total package in which all electronic components for said transmitter-receiver circuits, including the partial packages, are to be sealed.

Two or more related electronic components are sealed together as a single block in each partial package, and each partial package can be independently inspected for appropriate electrical characteristics. Either the partial packages or the total package or both are of hermetically sealed structure.

The adoption of the above-described configuration for the transmitter-receiver module operating on millimeter wave and other frequency bands enables the costs of the module to be reduced, its measurement reliability to be guaranteed, and its inspection time to be saved.

## Description

### FIELD OF THE INVENTION

The present invention relates to a transmitter-receiver module for use on millimeter wave or semi-millimeter wave bands.

### BACKGROUND OF THE INVENTION

In recent years, the vehicle-equipped radar units and communications systems that use millimeter wave or semi-millimeter wave bands have been developed in the automobile environment.

For the millimeter wave radar units that are used with vehicle-to-vehicle distance and obstructions detection systems, antennas and transmitter-receiver circuits have been integrated into modules to enhance the mounting density of the radar components (references: Japanese Application Patent Laid-Open Publication Nos. Hei 10-79623, Hei 11-4118, and so on). The components to be used in such transmitter-receiver circuits, especially, oscillators, power amplifiers, frequency converters (down-converters), and the like, are structured as integrated circuits (ICs), and these IC dies, capacitors, and other electronic components are mounted on circuit boards. The use of high-frequency levels such as millimeter wave or semi-millimeter wave frequency bands, in particular, requires anti-moisture protection of high-frequency ICs. If IC dies and other electronic components are directly coated with resin for the purpose of anti-moisture protection, since the resin has a relatively large dielectric constant, signal loss (output loss) will arise from the resulting influences. In general, therefore, all such components required are encased in a single package having an internal space, and then this package is hermetically sealed. Hermetic sealing is formed in an inert gas atmosphere such as a nitrogen gas atmosphere, and antenna elements, IC dies, capacitors, and other electronic components are protected with a sealing cover, which is then connected to a circuit board or the like by brazing, laser welding, electric welding, or the like.

Other packaging technology suitable for high-frequency signal-use ICs includes independent packaging of each electronic component, such as an IC die, that requires hermetic sealing. It is described in, for example, Japanese Application Patent Laid-Open Publication Nos. Hei 11-251469 and Hei 11-26645, that for high-frequency-use ICs, since the characteristic dielectric constants and loss coefficients of polymer sealing materials cause the losses of gain and output during the propagation of high-frequency signals, the use of IC packages having a cavity inside each are preferable.

During the selection of an IC die, its electrical characteristics are checked. When the selected IC die is measured under its bare status, however, since measurement probes are brought into direct contact with the electrodes of the IC die, damage due to contact of the probes is prone to be applied to the IC itself. For use at high-frequency levels such as millimeter wave bands, it is desired that such application of damage should be minimized to improve the reliability of the data measured.

For an independently packaged IC die, its characteristics can be inspected using measurement probes connected to the exposed terminals of the package, and even when the IC die is inspected alone, the reliability of measurement is ensured without the IC die being damaged, since the die is protected by the package. However, these packaging methods increase the number of packages required, and hence, costs. Also, independent inspection of each electronic component to be inspected is a time-consuming task.

The present invention is based on the situations described above, and its object is to provide a transmitter-receiver module which can be used on millimeter wave and other frequency bands, and which can minimize costs and reduce inspection time with guaranteed measurement reliability.

### SUMMARY OF THE INVENTION

In order to achieve the above object, the present invention basically proposes the following transmitter-receiver modules:
One module has partial packages in which only some of the IC dies and other electronic components constituting the transmitter-receiver circuits for use on millimeter wave or semi-millimeter wave bands are to be sealed, and a total package in which all electronic components for the aforementioned transmitter-receiver circuits, including said partial packages, are to be sealed,
wherein the module is characterized in that two or more related electronic components are sealed together as a single block in each partial package, in that independent inspection of electrical characteristics is possible for each partial package, and in that either the partial packages or the total package or both are of hermetically sealed structure.

Another module is such that said partial packages are cavity packages of the structure provided with hermetic sealing or semi-hermetic sealing, such that two or more related electronic components are sealed together as a single block in each partial package, and such that said total package is resin-coated. The terms "hermetic sealing" and "semi-hermetic sealing" here are defined as follows:
Hermetic structure is structure designed so as to maintain hermetically sealed status during the years of practical use, and applies to, for example, the structure in which the connections that require sealing are connected by brazing or soldering. Semi-hermetic structure is structure which, although it can initially maintain the hermeticalness of a practical level, becomes non-hermetic in the long run, and applies to, for example, the structure in which the connections that require sealing are connected using organic adhesive materials or the like.

A yet another module is such that the IC dies and other electronic components constituting the transmitter-receiver circuits for use on millimeter wave or semi-millimeter wave bands are formed by collectively coating all such components with a resin material of a low dielectric constant and then recoating these components with a general-purpose resin material of a relatively high dielectric constant.

### BRIEF DESCRIPTION OF THE DRAWINGS

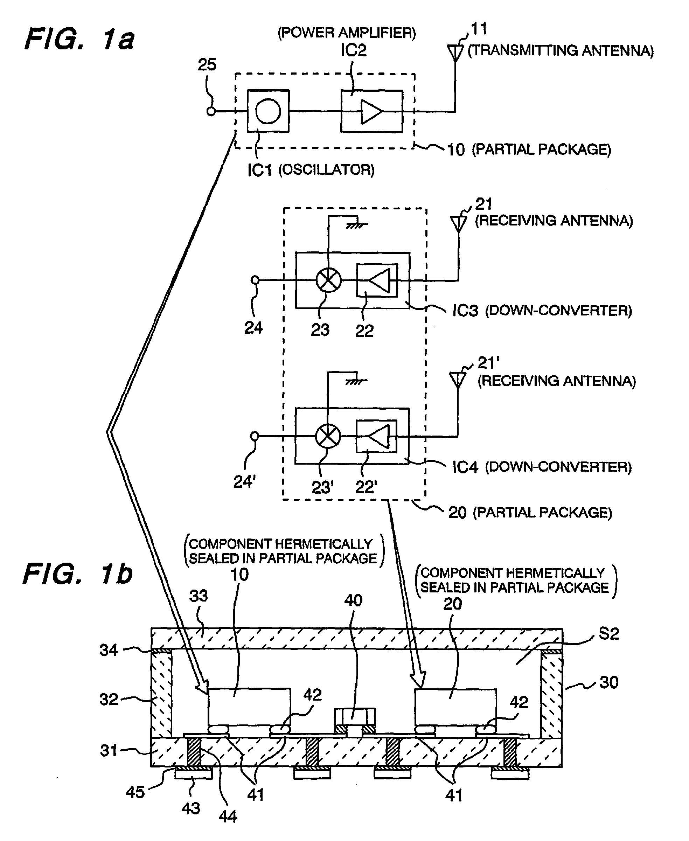

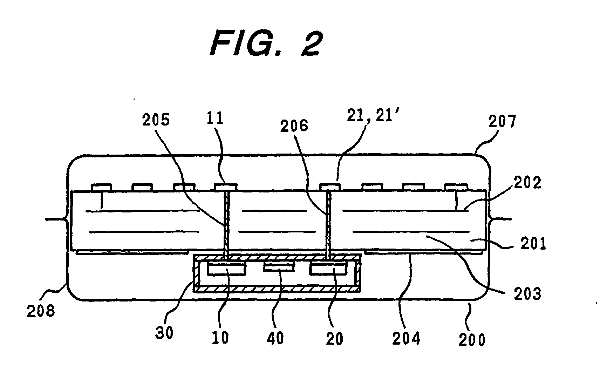

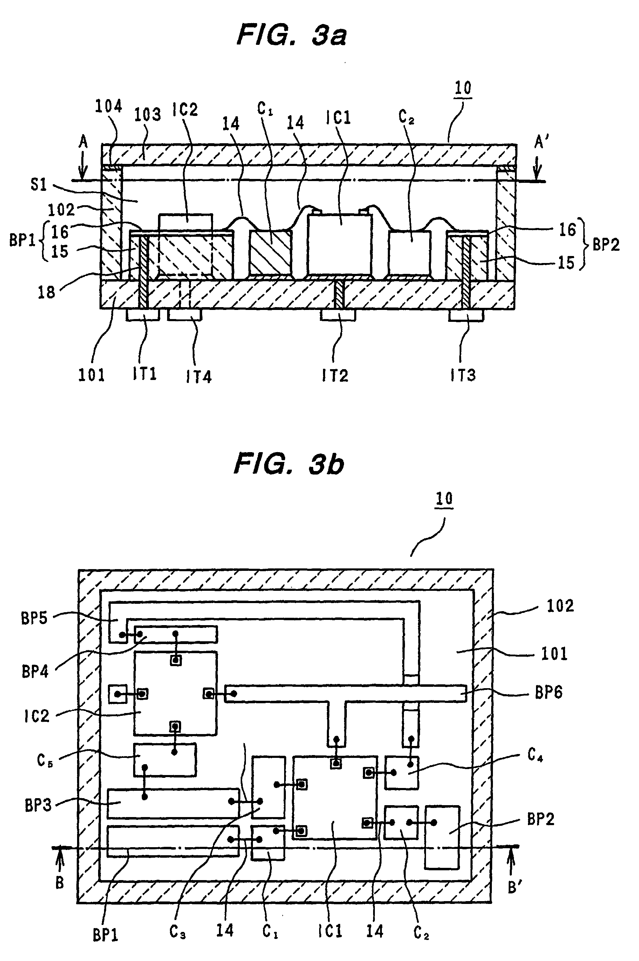

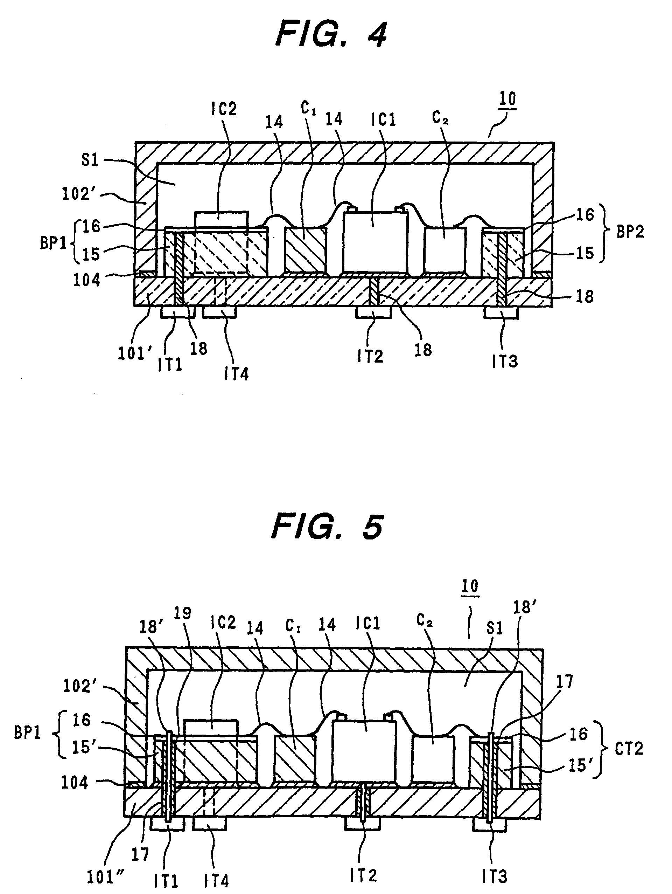

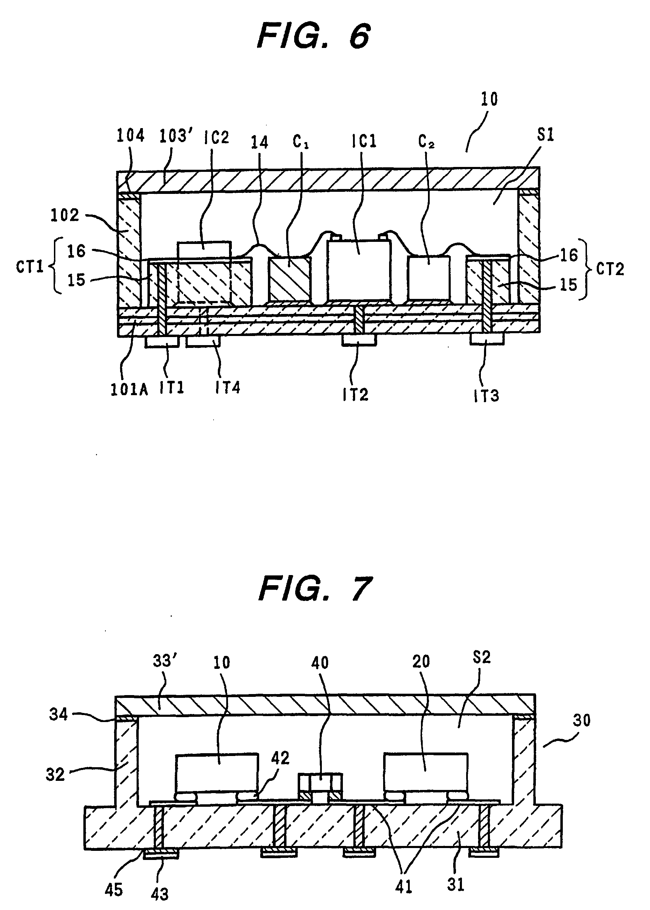

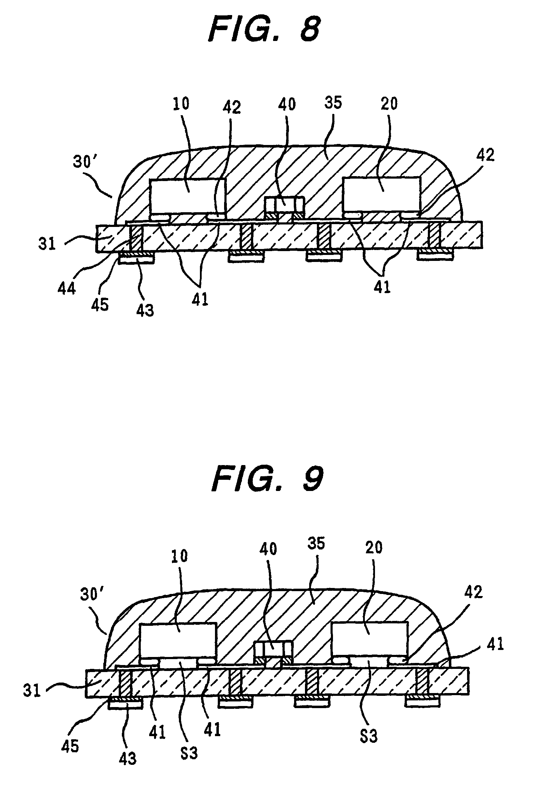

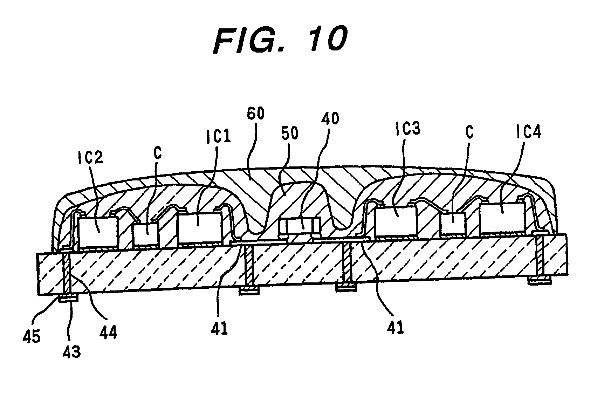

Fig. 1(a) is a transmitter-receiver module circuit block diagram showing examples of the objects to which the present invention can be applied. Fig. 1(b) is a cross-sectinal view of the total package used in the transmitter-receiver module of Fig. 1(a). Fig. 2 is a cross-sectional view showing schematically a millimeter wave radar unit having the above transmitter-receiver module mounted thereon. Fig. 3(a) is a profile view showing one partial package of the above transmitter-receiver module, wherein the B-B' section in Fig. 3(b) is cross-sectionally shown. Fig. 3 (b) is a cross-sectional view of the A-A' section in Fig. 3(a). Fig. 4 is a cross-sectional view of one partial package pertaining to a second embodiment of the present invention. Fig. 5 is a cross-sectional view of the partial package 10 pertaining to a third embodiment of the present invention. Fig. 6 is a cross-sectional view of the partial package 10 pertaining to a fourth embodiment of the present invention. Fig. 7 is a cross-sectional view of the total package 30 pertaining to a fifth embodiment of the present invention. Fig. 8 is a cross-sectional view of the transmitter-receiver module pertaining to a sixth embodiment of the present invention. Fig. 9 is a cross-sectional view of the transmitter-receiver module pertaining to a seventh embodiment of the present invention. Fig. 10 is a cross-sectional view of the transmitter-receiver module pertaining to an eighth embodiment of the present invention.

### DESCRIPTION OF THE PREFERRED EMBODIMENTS

Embodiments of the present invention are described below using drawings.

The millimeter wave radar unit in a first embodiment is intended to be mounted, for example, in an automobile and applied to vehicle-to-vehicle distance warning and adaptive cruise control (ACC), and the operating frequency assumed is of the order of several tens of gigahertz (GHz).

As shown in Fig. 1, radio waves of the required millimeter wave band are transmitted from an transmitting antenna 11, then after the waves reflected from a target such as a vehicle have been received at receiving antennas 21 and 21', and the Doppler modulation characteristics of the received waves against the transmitted waves are detected. Thus, the distance and relative speed with respect to the target are detected.

In this embodiment, two receiving antennas (left and right) are used. The relative speed and direction angle of the target in front with respect to the radar beam are detected by processing the signals received from both antennas.

The transmitter in the transmitter-receiver module comprises components such as a semiconductor integrated circuit 1 (IC1) that constitutes an oscillator (for example, a voltage controlled oscillator), and IC2 that constitutes a power amplifier. Hereinafter, IC1 and IC2 are referred to as oscillation IC1 and power IC2, respectively.

Oscillation IC1 receives modulation signals from a modulation signal generator (not shown in the figure) via an input terminal 25, and creates millimeter wave signals of the required frequency.

The receiver in the transmitter-receiver module is equipped with a down-converter (frequency converter) IC3, which performs frequency conversions on the signals received by antenna 21, and a down-converter IC4, which performs frequency conversions on the signals received by antenna 21'. The down-converter IC3 comprises a low-noise amplifier 22 and a mixer 23, and the down-converter IC4 comprises a low-noise amplifier 22' and a mixer 23'. After the signals that were received by antennas 21 and 21' have been mixed with transmitted signals by the mixers 23 and 23', the mixed signals are sent to a signal processing unit (not shown in the figure) via output terminals 24 and 24', then data concerning both received signals, such as phase differences, is calculated, and finally, the distance and relative speed of the vehicle having the mounted module, with respect to the target, are calculated by a microcomputer. The IC1 to the IC4 each consist of an IC die (IC chip).

As shown in Fig. 1 (b), the transmitter-receiver module in this embodiment basically consists of partial packages 10 and 20, in which only some of electronic components are to be sealed, and a total package 30, in which all electronic components for the transmitter-receiver circuits, including the partial packages, are to be sealed.

In partial packages 10 and 20, a plurality of ICs are packaged in the lump for each group whose common electrical characteristics can be inspected on a transmitter-receiver function block unit.

The oscillation IC1 and power IC2 of the transmitter are contained together in partial package 10. The down-converters IC3 and IC4 of the receiver are sealed together in partial package 20. And these partial packages 10 and 20 are mounted, via solder 42 and together with other related electronic components such as a layered chip capacitor 40, on a circuit board 31 surface-formed with conductor patterns 41.

The total package 30 consists of a circuit board 31, a casing 32 that forms the receiving space for the components on the circuit board 31, and a sealing cover 33 for covering the casing 32. In this embodiment, these package components 31, 32 and 33 are formed using a ceramic material.

Next, the internal structure of the above-described partial packages is described using Fig. 3. Fig. 3 exemplifies the internal structure of the partial package 10. The internal structure of the partial package 20 is not described since the package structure is basically the same as that of the partial package 10.

The partial package 10 is a cavity package composed of a circuit board 101, a casing 102 that forms the receiving space for the components on the circuit board 101, and a sealing cover 103. In this embodiment, the circuit board 101, the casing 102, and the sealing cover 103 are made of a ceramic material. The circuit board 101, the plurality of ceramic terminal blocks 15 arranged on the surface thereof, and the casing 102 are all connected by sintering to form a single block.

Terminal blocks 15 have an electroconductive film 16 formed on the respective surfaces to function as wire bonding pads (circuit terminals) BP. The via-holes running through the terminal blocks 15 and the circuit board 101 are each filled with a conductor 18, through which the wire bonding pads BP and the intermediate terminals IT provided on the reverse side of the circuit board are electrically connected.

In Figs. 3 and 4, six wire bonding pads BP are shown and these pads are represented as BP1 to BP6. Likewise, four intermediate terminals IT are shown and these terminals are represented as IT1 to IT4.

Oscillation IC1, power IC2, and related single-layer capacitors C1, C2, C3, C4, and C5 are mounted on the circuit board 101 of the partial package 10, and these electronic components are electrically connected via wire bonding 14 and accommodated in package casing 102. After these electronic components have been accommodated, cover 103 is connected to casing 102 under a nitrogen gas atmosphere to provide the inside of the package with hermetic sealing. Cover 103, by being connected to casing 102 by brazing or soldering, maintains the internal hermeticalness of the package, and by being internally charged with an inert gas such as a nitrogen gas, constitutes the cavity package.

The use of this cavity package enables oscillation ICs, power ICs, down-converter ICs, and the like, to be protected from moisture and thus from deterioration in characteristics, during operation on semi-millimeter wave or millimeter wave bands, in particular.

Partial packages 10 and 20 and other electronic components are mounted by bonding on the circuit board 31 of the total package 30 via the intermediate terminals IT1 to IT4 provided on the reverse side of the circuit board, and via the solder 42 shown in Fig. 1 (b). Such bonding provides partial packages 10 and 20 with electrical connection to the electroconductive patterns 41 and layered capacitors 40 on circuit board 31.

Total package 30, by having its cover 33 bonded onto casing 32 via a brazing material or a bonding material 34 such as solder, provides partial packages (IC packages) 10 and 20, other electronic components 40, and the like, with hermetic sealing.

Total package is also a cavity package having a space S2 therein.

Although, in this embodiment, the total package 30 itself is also provided with hermetic sealing, since the components that require hermetic sealing are already hermetically sealed via the partial packages, hermetic structure does not always need to be adopted for the total package and non-hermetic or semi-hermetic structure can also be adopted.

As earlier defined in this SPECIFICATION, semi-hermetic structure is structure which, although it can initially maintain the hermeticalness of a practical level, becomes non-hermetic in the long run. For example, if semi-hermetic structure is to be adopted for the total package, this can be implemented by bonding the casing 32 and the cover 33 by use of an organic adhesive. The use of an organic adhesive for achieving hermetic sealing enables cost reduction in comparison to the use of an hermetic bonding material such as a brazing material or solder. Conversely, provided that hermetically sealed structure is adopted for the total package 30, the intended purpose of hermetic sealing can be achieved for partial packages 10 and 20, even if the latter two packages are of semi-hermetic or non-hermetic structure.

Fig. 2 is a cross-sectional view showing schematically the internal structure where the total package (high-frequency transmitter-receiver module) 30 is further built into a millimeter wave radar module 200. The millimeter wave radar module 200 has transmitting-receiving antenna patterns 11, 21, and 21' formed on one side of, for example, a multi-layer ceramic circuit board 201, and a transmitter-receiver module 30 on the other side. The transmitting antenna pattern 11 and the power IC output terminals of the partial package 10 are electrically connected via a conductor 205 running through the multi-layer ceramic circuit board 201. The receiving antenna pattern 21 and 21' are electrically connected to the signal input terminals of the partial package 20 via a conductor 206 running through the multi-layer ceramic circuit board 201. Elements, such as an electroconductive film 202 for providing antenna grounding, electroconductive film 203 for supplying power to the transmitter-receiver module, intervene between the layers of the ceramic circuit board 201, and electroconductive patterns 204 are formed on one side of the circuit board 201. These millimeter wave radar components are accommodated in a casing 208 and shielded with a redome 207.

According to this embodiment, since, on both partial packages 10 and 20, two or more IC dies are sealed together for each common or related block function, the electrical characteristics of two or more IC dies can be independently inspected on a partial package unit. Although such inspections are performed during defective/nondefective component screening, independent inspection of the partial package 10 is possible by applying test signals (equivalent to frequency modulation signals) to the input terminals provided on the reverse side of the corresponding circuit board 101, and then measuring outputs via the output terminals provided on the reverse side of the package circuit board 101. That is to say, if any defects are detected in either IC1 or IC2, these defects will appear as the deterioration in the output characteristics of the power IC2, in measurement results, and in that case, the partial package will be recognized as a defective product, with the result that the partial package itself will be excluded as a defective.

Independent inspection of the partial package 20 is possible by applying test signals (equivalent to receiving antenna signals) to the input terminals provided on the reverse side of the package circuit board, and then analyzing the frequency response of the resulting output signals via the output terminals provided on the reverse side of the package circuit board.

According to this embodiment, the improvement of millimeter wave radars in terms of reliability and the reduction of their costs can be realized since the embodiment has the following advantages: (1) the fact that the ICs of the transmitter-receiver circuits are protected by the partial packages of the cavity type ensures the reliability of measurement of the transmitter-receiver module which uses millimeter waves or semi-millimeter waves; (2) also, when components are manufactured, IC damage can be avoided since measurement probes do not need to be brought into direct contact with each IC during defective/nondefective component screening; (3) in addition, even if the partial packages are sealed with ICs, inspection time can be reduced since a plurality of ICs are packaged for each group whose common electrical characteristics can be inspected on a transmitter-receiver function block unit, instead of each IC being packaged independently; (4) compared with independent packaging of each component, the above packaging scheme enables reduction in the number of packages and hence, in costs; and (5) besides, sealing costs can be minimized since hermetic sealing needs to be adopted only for either the partial packages or the total package.

In addition to the above-described embodiment, the following various modes of embodiment are possible for the partial packages pertaining to the present invention:
Fig. 4 is a cross-sectional view of the partial package 10 pertaining to a second embodiment of the present invention, wherein the electronic components packaged inside are the same as in the aforementioned embodiment of Fig. 3 (the first embodiment).

The second embodiment differs from the first embodiment in that the circuit board 101' of the partial package 10 is of the glass ceramic type, in that the cover 102' also functions as the casing of the package, and in that the cover 102' is metallic. Cover 102' is connected to circuit board 101' by use of a brazing material or a bonding material 104 such as solder.

Fig. 5 is a cross-sectional view of the partial package 10 pertaining to a third embodiment of the present invention, wherein, although the cover 102' functions as the package casing as well, the cover 102', the circuit board 101" and the terminal block 15' are metallic. The terminal block 15' is connected to the circuit board (metal base) by welding.

Since terminal block 15' and circuit board 101" are metallic, the conductor 18' (equivalent to the conductor 18 shown in Figs. 1 to 4) that runs through the through-holes in terminal block 15' and circuit board 101" is hermetically sealed with a member 19 (for example, glass sealing member) that has an electrical insulating property.

Fig. 6 is a cross-sectional view of the partial package 10 pertaining to a fourth embodiment of the present invention, wherein the fourth embodiment differs from the first embodiment in that the circuit board 101A of the partial package 10 is a multi-layer ceramic board and in that the cover 103' is bonded onto casing 102 by use of an organic adhesive 104 to realize package 10 of semi-hermetically sealed structure.

Fig. 7 is a cross-sectional view of the total package 30 pertaining to a fifth embodiment of the present invention, wherein the circuit board 31 and casing 32 of the total package are molded into a single block by use of a ceramic material and then a metallic or ceramic cover 33' is bonded onto the molded block.

Fig. 8 is a profile view of the transmitter-receiver module pertaining to a sixth embodiment of the present invention. In this embodiment, as in the other embodiments described above, the partial packages 10 and 20 are cavity packages of hermetically or semi-hermetically sealed structure. Total package 30' is composed of a circuit board 31 and a resin (coating) 35 that was so formed as to cover the entire section consisting of the electronic components 10, 20, 40, etc. mounted on the circuit board 31. The resin 35 is epoxy-based or silicone-containing synthetic resin. The resin 35 is porus resin and non-hermetic structure. Even if the IC packages 10 and 20 constituting the transmitter-receiver components of the millimeter or semi-millimeter wave band type are covered with the normal insulating resin 35 that has a relatively high dielectric constant, dielectric loss (gain/output loss) can be minimized since the IC packages are cavity packages as described earlier. According to this embodiment, module costs can be reduced since the total package consists of the board 31 and the resin 35.

Fig. 9 is a cross-sectional view of the total package 30 pertaining to a seventh embodiment of the present invention, wherein the basic composition of the module is almost the same as adopted in the sixth embodiment. The difference from the sixth embodiment exists in that all the electronic components 10, 20, and 40 on board 31, including the partial packages 10 and 20, are provided with coating (resin molding) to create voids (spaces) S3 between the partial packages and the board 31.

The creation of these spaces S3 provides the following advantages:
In the case that electroconductive patterns are formed at the bottom patterns of the partial packages 10 and 20, namely, on the facing surface of the partial packages and the total package, if the wiring density at the corresponding section is high and resin intervenes between the partial packages and the total package, increases in capacitance due to the presence of the resin are likely to arise during the use of millimeter or semi-millimeter waves. However, this problem can be coped with by employing the aforementioned seventh embodiment.

Fig. 10 is a cross-sectional view of the transmitter-receiver module pertaining to an eighth embodiment of the present invention.

According to this embodiment, measurement reliability concerning high-frequency radio waves such as millimeter or semi-millimeter waves can be guaranteed, even for a resin-coated type of transmitter-receiver module not using the partial packages (cavity packages) described earlier.

In this embodiment, the IC dies (IC1 to IC4), capacitors C, layered capacitors 40, and other electronic components constituting the transmitter-receiver circuits operating on millimeter or semi-millimeter wave bands are all collectively(simultaneously) coated with the resin 50 that has a low dielectric constant (3 or less in terms of specific dielectric constant), and this coated surface is further coated with a general-purpose resin material 60 whose dielectric constant is greater than that of the above-mentioned resin.

The materials that can be used as the low-dielectric-constant resin 50, include, for example, Parylene N (specific dielectric constant: 2.6 - 2.7), Parylene F (specific dielectric constant: 2.3 - 2.4), polyimidesiloxane (specific dielectric constant: 2.6-2.7), polyimide F (specific dielectric constant: 2.4 - 2.5), or the like. For example, epoxy-based resin or silicone-based resin can be used as outer-layer protection resin 60.

According to this embodiment, as with the packages of the cavity type, resin-coated packages capable of suppressing the loss of high-frequency response during the use of millimeter waves or semi-millimeter waves can be achieved by using low-dielectric-constant resin 50 for inner-layer resin coating of the package elements required. Concerning the low-dielectric-constant resin 50, in particular, even if its dielectric constant is reduced by increasing its hole ratio, moisture resistance can be improved by construction the outer-layer resin 60 by use of highly dense resin (resin low in hole ratio), and the transmitter-receiver module of a millimeter wave radar, for example, can be improved in reliability and reduced in costs.

### INDUSTRIAL APPLICABILITY

According to the present invention, it is possible, as described above, to provide such a transmitter-receiver module operating on millimeter wave or semi-millimeter wave bands that is capable of minimizing costs, ensuring measurement reliability, and saving inspection time.

## Claims

1. A transmitter-receiver module having a partial package in which only some of electronic components constituting the transmitter-receiver circuits for use on millimeter wave or semi-millimeter wave bands are to be sealed, and a total package in which all electronic components for said transmitter-receiver circuits, including said partial package, are to be sealed,
wherein said module is **characterized in that** two or more related electronic components are sealed together as a single block in the partial package, **in that** the partial package can be independently inspected for appropriate electrical characteristics, and **in that** either the partial package or the total package or both are of hermetically sealed structure.

2. Such transmitter-receiver module set forth in Claim 1 above, wherein said partial package is a cavity package and the IC die constituting an oscillator and the IC die constituting a power amplifier are sealed together in the partial package.

3. Such transmitter-receiver module set forth in Claim 1 above, wherein said partial package is a cavity package and two IC dies that constitute down-converters are sealed together in the package.

4. A transmitter-receiver module having a partial package in which only some of electronic components constituting the transmitter-receiver circuits for use on millimeter wave or semi-millimeter wave bands are to be sealed, and a total package in which all electronic components for said transmitter-receiver circuits, including said partial package, are to be sealed,
wherein said module is **characterized in that** said partial package is a cavity package of hermetically sealed structure or semi-hermetically sealed structure, **in that** two or more related electronic components are sealed together as a single block in the partial package, and **in that** said total package is provided with resin coating.

5. A transmitter-receiver module having a plurality of partial packages in which only some of electronic components constituting the transmitter-receiver circuits for use on millimeter wave or semi-millimeter wave bands are to be sealed, wherein said module is **characterized in that** two or more related electronic components are sealed together as a single block in each said partial package, **in that** each partial package is bonded onto a circuit board, **in that** the entire electronic component section of said circuit board, including each partial package, is resin-coated in batch form so as to create a space between each partial package and the circuit board.

6. A transmitter-receiver module **characterized in that** the ID dies and other electronic components constituting the transmitter-receiver circuits operating on millimeter or semi-millimeter wave bands are all collectively coated with a resin material of a low dielectric constant and **in that** the thus-coated surface is further coated with a general-purpose resin material whose dielectric constant is greater than that of the above-mentioned resin.
